Europäisches Patentamt

European Patent Office

Office européen des brevets

(11) Numéro de publication: **0 407 470 B1**

(12) **FASCICULE DE BREVET EUROPEEN**

(45) Date de publication de fascicule du brevet: **27.07.94**

(51) Int. Cl.5: **H01L 31/0352**, G02F 1/015, G02F 1/35, G02F 1/37

(21) Numéro de dépôt: **89906377.0**

(22) Date de dépôt: **26.05.89**

(86) Numéro de dépôt internationale : **PCT/FR89/00253**

(87) Numéro de publication internationale : **WO 90/06596 (14.06.90 90/14)**

(54) **DISPOSITIF DE DETECTION ET DE TRAITEMENT DE RAYONNEMENTS OPTIOUES.**

(30) Priorité: **06.12.88 FR 8815956**

(43) Date de publication de la demande: **16.01.91 Bulletin 91/03**

(45) Mention de la délivrance du brevet: **27.07.94 Bulletin 94/30**

(84) Etats contractants désignés: **DE FR GB**

(56) Documents cités:
EP-A- 0 155 802
WO-A- 90/06596
US-A- 4 745 452

Applied Physics Letters, vol. 47, no. 12, 15 décembre 1985, American Institute of Physics, (Woodbury, New York, US), K.W. Goossen et al. : "Grating enhanced quantum well detector", pages 1257-1259.

(73) Titulaire: **THOMSON-CSF**
**173, Boulevard Haussmann**
**F-75008 Paris(FR)**

(72) Inventeur: **ROSENCHER, Emmanuel**
**4, rue de la Participation**
**F-92220 Bagneux(FR)**
Inventeur: **BOIS, Philippe**
**7, square de la Prospérité**
**F-77240 Cesson(FR)**

(74) Mandataire: **Guérin, Michel et al**
**THOMSON-CSF**
**SCPI**
**B.P. 329**
**50, rue Jean-Pierre Timbaud**
**F-92402 Courbevoie Cédex (FR)**

Applied Physics Letters, vol. 45, no. 11, 1er décembre 1984, American Institute of Physics, (Woodbury, New York, US), F. Capasso et al. : "Pseudo-quaternary GaInAsP semiconductors : A new Ga0.47In0.53As/InP graded gap superlattice and its applications to avalanche photodiodes", pages 1193-1195.

IEEE Journal of Quantum Electronics, vol. QE-19, no. 5, mai 1983, IEEE, (New York, US), M.K. Gurnick et al. : "Synthetic nonlinear semiconductors", pages 791-794.

Applied Physics Letters, vol. 51, no. 25, 21 décembre 1987, American Institute of Physics, (New York, US), J. Khurgin : "Second-order susceptibility of asymmetric coupled quantum well structures", pages 2100-2102.

Electronics Letters, vol. 23, no. 20, 24 septembre 1987, (Stevenage, Herts., GB), K. Wakita et al. : "GaInAs/InP waveguide multiple-quantum-well optical modulator with 9dB on/off ratio", pages 1067-1069.

## Description

L'invention concerne un dispositif de détection et de traitement de rayonnements optiques.

Les détecteurs optiques à grandes longueurs d'ondes (supérieures ou égales à 5 micromètres) se regroupent en deux grandes familles principales de dispositifs :

- Les détecteurs à semiconducteurs à effet photo-électrique.
- Les détecteurs photo-thermiques.

Dans le premier cas, ces détecteurs ne fonctionnent qu'à basse température. En effet, le principe de fonctionnement de ces dispositifs repose sur la génération de porteurs libres par transition optique entre 2 niveaux d'énergie $E_1$ et $E_2$. Selon le type d'application :

. Le niveau d'énergie $E_1$ est le niveau piège et $E_2$, la bande de conduction pour les photoconducteurs extrinsèques.

. Le niveau d'énergie $E_1$ est la bande de valence, $E_2$ la bande de conduction pour les photoconducteurs intrinsèques, les photovoltaïques etc...

. $(E_2-E_1)$ est la hauteur de barrière dans un détecteur Schottky.

Si une onde électromagnétique permet une transition $(E_2-E_1)$ de faible valeur énergétique (110 meV par exemple), les phonons à température ambiante seront assez énergétiques (25 meV) et nombreux pour provoquer cette transition. En d'autre terme, le courant d'obscurité est très important dans un tel dispositif à la température ambiante et la détectivité du photodétecteur (comme son impédance) est extrêmement faible ($D^* \sim 10^6 cm. \sqrt{Hz}/W$) .

Dans le deuxième cas, c'est-à-dire dans les détecteurs photothermiques, l'augmentation de la température due à l'absorption de l'onde électromagnétique conduit à une variation de la constante diélectrique d'un matériau pyroélectrique. Contrairement à la première famille de dispositifs (détecteurs à semiconducteurs à effet photo-électrique), ces détecteurs fonctionnent a température ambiante. S'agissant de transitions optiques entre niveaux liés, la conductivité électrique de ces matériaux ne change pas, l'impédance des structures capacitives reste très grande, permettant de fortes amplifications.

Le document EP-A-316 909 décrit un dispositif à puits quantique asymétrique fonctionnant par transitions entre niveaux de la bande de valence et de la bande de conduction et détectant ainsi de courtes longueurs d'ondes.

L'invention a pour objet des structures à détection capacitive utilisant des transitions entre niveaux liés dans des puits quantiques asymétriques. Ces détecteurs présentent les avantages :

1. de fournir une très forte impédance même à la température ambiante ce qui permet une forte amplification et une utilisation comme détecteur à température ambiante.

2. de pouvoir être fabriqués par la technologie des semiconducteurs donc, présentant une possibilité d'intégration dans un système a semiconducteurs.

L'invention concerne donc un dispositif de détection de rayonnements optiques, comprenant un cristal non linéaire comportant un empilement d'au moins deux couches en matériaux à largeur de bandes interdites différentes constituant au moins un puits quantique à structure asymétrique, cet empilement de couches étant enserré entre deux couches barrières en matériau de largeur de bande interdite supérieure a celles des couches de l'empilement ; ledit puits comportant un premier niveau d'énergie E0 situé dans la partie profonde du puits et un deuxième niveau d'énergie E1 située dans la partie moins profonde du puits, la détection et le traitement d'une onde optique se faisant par transition d'électrons entre ces deux niveaux, des électrodes étant situées sur les couches barrières en vue de connecter un dispositif de mesure de tension.

L'invention concerne également un procédé de réalisation d'un dispositif de détection tel que revendiqué dans la revendication 7, un dispositif de modulation electro-optique tel que revendiqué en revendication 8 ainsi qu'un dispositif de doublage de fréquence tel que revendiqué en revendication 10.

Les différents objets et caractéristiques de l'invention apparaîtront plus clairement dans la description qui va suivre faite à titre d'exemple en se reportant aux figures annexées qui représentent :

- la figure 1, un exemple de structure selon l'invention ;
- la figure 2, un diagramme d'énergie selon l'invention ;
- la figure 3, un diagramme d'un empilement de puits quantiques selon l'invention ;
- la figure 4, une courbe de variation du coefficient de redressement optique en fonction de la longueur d'onde incidente ;
- la figure 5, une structure intégrée du dispositif de la figure 1 avec un transistor à effet de champ ;
- la figure 6, un diagramme d'un empilement de puits quantiques montrant la polarisabilité de la structure ;
- la figure 7, une courbe de variation du coefficient de doublage en fréquence ;
- la figure 8, un dispositif de détection optique par hétérodynage ;
- la figure 9, un exemple de dispositif de modulation électro-optique selon l'invention ;

- la figure 10, un exemple de dispositif de doublage de fréquence optique selon l'invention.

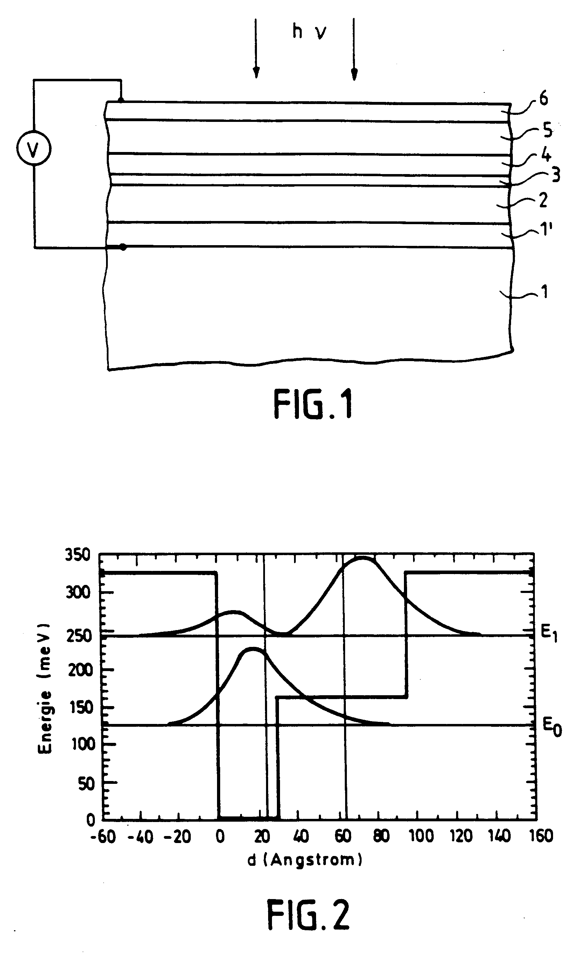

La figure 1, représente une structure simplifiée d'un détecteur selon l'invention et la figure 2 un diagramme d'énergie de ce détecteur. Ce détecteur comporte sur un substrat 1 deux couches de matériaux semiconducteurs différents 3 et 4 enserrées entre deux couches 2 et 5 d'un même matériau semiconducteur. Les matériaux de ces différentes couches sont choisis de façon que les couches 3 et 4 constituent un puits quantique asymétrique tel que représenté en figure 2. Pour cela les matériaux des couches 3 et 4 possèdent des potentiels de conduction différents.

A titre d'exemple, les matériaux choisis peuvent être les suivants :
- pour le substrat 1 : du Ga As dopé d'impuretés ou du Ga As semi-isolant avec une couche tampon 1' dopé n$^+$ de GaAs ;
- pour la couche 2 : du Al$_x$ Ga$_{1-x}$ As avec x compris entre 0 et 1 ;
- pour la couche 3 : du Ga As ;
- pour la couche 4 : du Al$_y$ Ga$_{1-y}$ As avec y compris entre 0 et x ;
- pour la couche 5 : du Al$_x$ Ga$_{1-x}$ As avec x compris entre 0 et 1 (même x que pour la couche 2 ;
- pour la couche 6 : du Ga As dopé d'impureté de type n$^+$.

Des prises de contacts sont réalisées sur les couches 1 et 6 de façon à connecter un dispositif V de mesure de potentiel de charges.

Il est à noter que d'autres hétérostructures peuvent être envisagées telles que des hétérostructures à base de Si/Si Ge ou In Ga As/In Al As, etc...

L'essentiel est de réaliser un dispositif à puits quantique asymétrique tel que représenté en figure 2.

Sur la figure 2, on a indiqué la position du niveau fondamental E$_o$ et le niveau excité E$_1$, ainsi que les probabilités de présence des électrons dans chacun des niveaux. La composition et la largeur des puits quantiques ont été optimisées de telle sorte que E$_1$-E$_o$ corresponde à la longueur d'onde que l'on veut détecter. Le barycentre des charges dans chacun des niveaux est aussi indiqué. Sous illumination, la transition entre les deux niveaux va provoquer l'apparition d'un dipôle détectable électriquement, entre les charges fixes du puits le plus profond et les charges sur le niveau E$_1$. Cette asymétrie va engendrer, en plus, des phénomènes d'optique non linéaire tels que la rectification optique et l'hétérodynage.

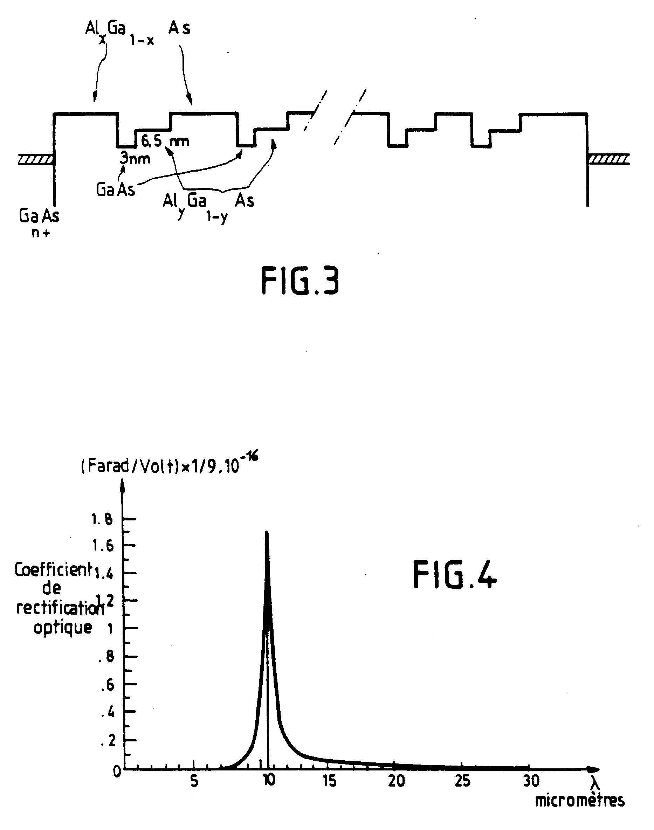

La figure 3, représente une structure constituée d'un empilement de puits quantiques de compositions asymétriques tel que celui des figures 1 et 2.

A titre d'exemple, les couches de chaque puits quantique, correspondant aux couches 3 et 4 de la figure 1, ont pour épaisseurs 3 nm et 6,5 nm pour un fonctionnement à 10,6 $\mu$m. Les couches barrières encadrant chaque puits (2 et 5 sur la figure 1) ont pour épaisseurs 30 nm.

La couche 3 peut contenir une densité électronique entre quelques 10$^{17}$ par cm$^3$ et quelques 10$^{18}$ par cm$^3$ provenant d'un dopage de la structure, par exemple du dopage de la couche 3 elle-même.

Les coefficients de composition des matériaux Al$_x$ Ga$_{1-x}$ As et Al$_y$ Ga$_{1-y}$ As ont dans cet exemple de réalisation les valeurs suivantes :

x = 0,4
y = 0,2

A température ambiante, avec une structure à base de Ga As et Al Ga As, telle que décrite précédemment, si E$_1$-E$_o$ vaut 120 meV le rapport de population entre les deux niveaux est n$_1$/n$_o$ = 1%. Le niveau E$_o$ est pris suffisamment profond pour que la structure totale de la figure 3 soit isolante.

La détection d'un dipôle pourra se faire, selon l'invention, par détection du potentiel de charges de surface à l'aide du dispositif V de la figure 1.

Le potentiel de surface est dû à deux effets :
- un effet pyroélectrique résultant d'un échauffement provoqué par le rayonnement à détecter ;
- un effet de redressement optique du rayonnement à détecter.

En ce qui concerne l'effet pyroélectrique, un calcul quantique montre que, si l'on prend un dopage des puits de l'ordre de 10$^{11}$ cm$^{-2}$ avec une durée de vie de 0,14ps, la réponse d'une diode capacitive de 1$\mu$m d'épaisseur est de 10$\mu$V/W. cm$^{-2}$ à température ambiante, ce qui est aisément détectable.

En ce qui concerne l'effet de redressement optique, la figure 4 représente la variation du coefficient de redressement optique du milieu de détection (couches des puits quantiques)

$$D^0 = \omega - \omega$$

en fonction de la longueur d'onde incidente (voir le document "Quantum Electronics" (Second Edition) de AMNON YARIV publié par John Wiley and Sons Inc, New York, chapitre 16 - Introduction to Nonlinear Optics - Second Harmonic Generation, pages 407 à 409). A titre d'exemple, pour une longueur d'onde de 10,6 micromètres, on détecte un potentiel d'environ 1,6 microvolts, par Watt et centimètre carré aux bornes de la capacité. On constate bien qu'il y a résonance pour h$\nu$ = E$_1$-E$_0$.

Nous reprécisons que le signal détecté comprend la détection des effets pyroélectriques, de redressement optique et photo-capacitif.

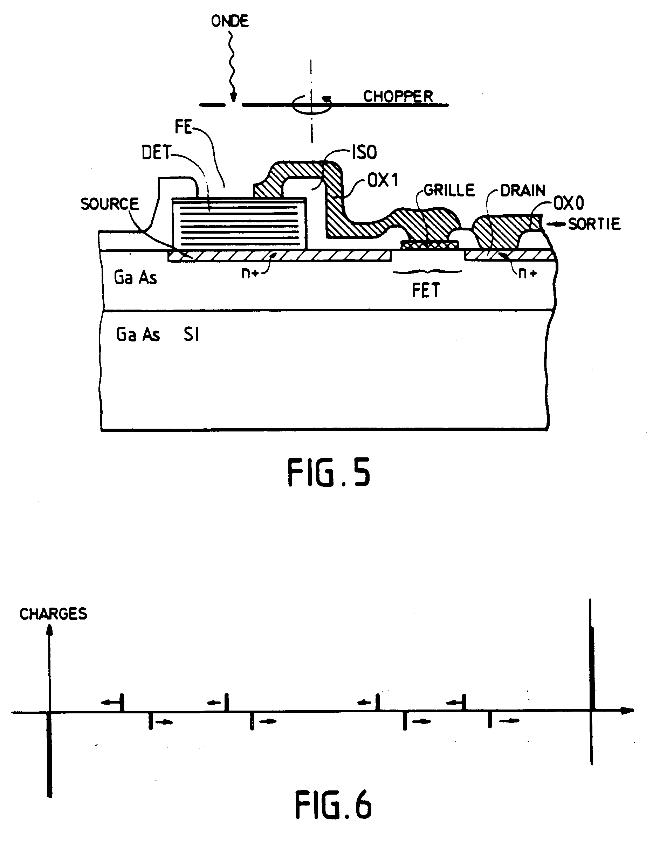

Par ailleurs, le rayonnement reçu par les dispositifs des figures 1 ou 3 peut induire une variation d'indice effectif du milieu. En effet, l'apparition des dipôles va modifier la polarisabilité statique du milieu comme cela est illustré sur la figure 6. Sur cette figure, les flèches désignent les mouvements des dipôles sous l'influence d'un champ électrique alternatif pour la mesure capacitive des dipôles. Cette polarisabilité va pouvoir être détectée aisément dans un pont de Wheastone ou un circuit accordé à inductances, résistances, capacités.

Afin d'augmenter la sensibilité, on peut moduler la lumière par un modulateur mécanique ou électro-optique.

Un dispositif de détection dont le fonctionnement obtenu par détection d'un potentiel à la surface du dispositif est réalisé selon l'invention par une structure de détection à puits quantiques asymétriques est intégré à la source ou à la grille d'un transistor à effet de champ.

La figure 5 représente un tel dispositif intégré dans lequel le dispositif de détection DET, constitué d'un empilement de puits quantiques asymétriques, est intégré à la source d'un transistor à effet de champ.

Selon la figure 5, la structure selon l'invention est réalisée à titre d'exemple en arséniure de gallium :

- sur un substrat Ga As semi-isolant, une couche de Ga As dopé n et comportant deux zones dopées $n^+$ constituant la source et le drain ;
- une couche métallique constituant la grille du transistor et située entre les deux zones dopées $n^+$ ;
- le dispositif de détection DET constitué d'un empilement de puits quantiques asymétriques et situé sur la zone dopée $n^+$ de la source du transistor ;
- une couche d'isolant ISO permettant d'isoler les flancs du dispositif de détection ainsi que des connexions du transistor ;
- une connexion métallique CX1 permettant de connecter la face supérieure de dispositif DET à la grille du transistor ;
- une connexion métallique CXO connectée au drain du transistor et fournissant un signal de sortie.

La face supérieure du dispositif DET possède une fenêtre FE ne comportant ni isolant ni connexion métallique et permettant à un rayonnement d'agir sur le dispositif DET.

Le rayonnement peut être transmis au dispositif DET par un dispositif de modulation mécanique ou électrooptique tel que cela est représenté sur la figure 5.

Le dispositif DET permet ainsi de créer une différence de potentiel entre la source et la grille. On détecte sur la connexion de drain CXO un signal de sortie proportionnel à l'intensité de rayonnement fourni au dispositif DET.

Le dispositif de l'invention petit également être appliqué à un dispositif de détection optique par hétérodynage.

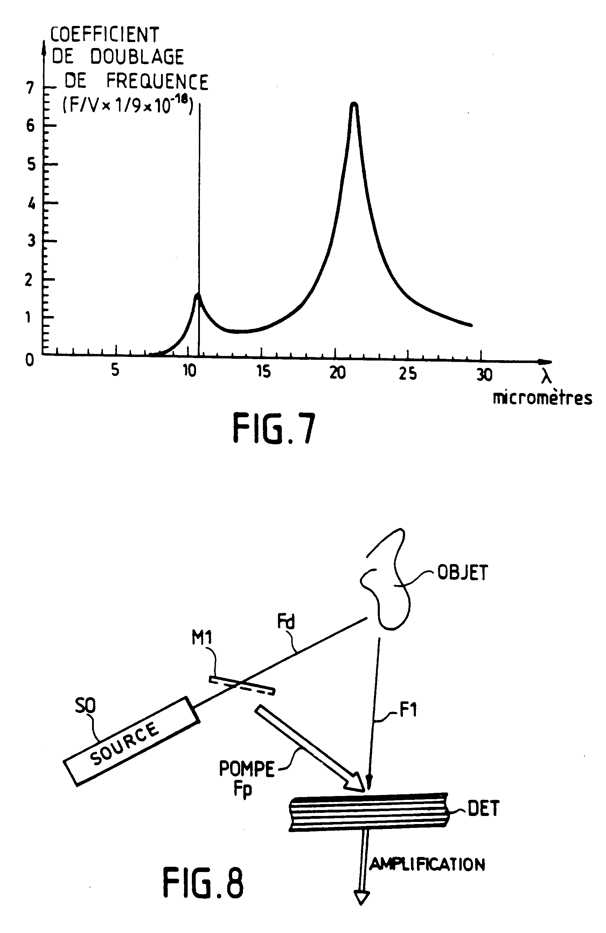

Comme déjà indiqué, la dissymétrie des fonctions d'onde des différents états quantifiés de la structure induit un coefficient de non linéarité, optique $d^2\ ^{\omega=\ \omega+\ \omega}$ très important (voir documents de AMNON YARIV cité précédemment ainsi que "Synthetic Nonlinear Semiconductors" de M.K. GURNICK et al publié dans IEEE Journal of Quantum Electronics N° 5 de May 1983 et "Electric field control of optical second-harmonic generation in a quantum well" de L. TSANG publié dans Applied Physics Letters 52 (9) du 29 février 1988. La figure 7 représente les valeurs calculées du coefficient de doublage optique de la structure $d^2\ ^{\omega\ =\ \omega\ +\ \omega}$ pour l'exemple traité à la figure 1. Pour une longueur d'onde de 10,6μm, le coefficient non linéaire est de 17 000 (1/9.10$^{-22}$ M K SA) à comparer avec 72 pour le GaAs pur (même unité). Ceci permet d'utiliser les multipuits quantiques asymétriques pour la détection hétérodyne entre le signal à détecter et un faisceau de pompe.

La figure 8 représente donc un dispositif permettant une telle détection. Ce dispositif comprend une source laser émettant un faisceau laser vers une lame semi-réfléchissante qui retransmet d'une part, un faisceau de détection Fd vers un objet à détecter, et d'autre part, un faisceau de pompe Fp au dispositif de détection DET constitué d'un empilement de puits quantiques.

Le dispositif DET reçoit un faisceau F1 provenant de la réflexion du faisceau Fd par l'objet à détecter. Le faisceau F1 est amplifié dans le dispositif DET par le faisceau de pompe Fp. Un faisceau amplifié est ainsi fourni par le dispositif DET et est aisément détectable.

Comme cela a été mentionné précédemment l'invention est applicable à la détection des effets pyroélectriques, de redressement optique et photo-capacitif.

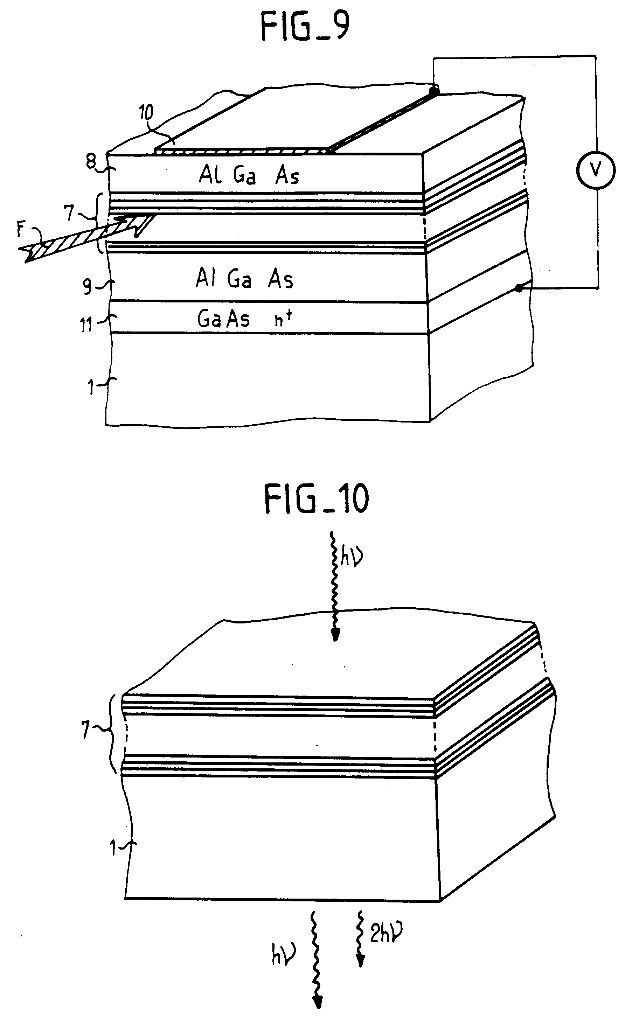

On va décrire, en se reportant à la figure 9, l'application de l'invention à un dispositif de modulation électro-optique.

Le dispositif de modulation électro-optique de la figure 9 comporte une couche d'un cristal non linéaire 7 constitué d'un empilement de couches de matériaux de gaps différents de façon à fournir un empilement de puits asymétriques (multi-puits quantiques asymétriques) tel que décrit precédemment et notamment tel que représenté en figure 3. La couche de cristal non linéaire 7 est enserrée entre deux couches d'un matériau de guidage optique 8 et 9. Ces couches 8 et 9 sont par exemple en arséniure de Gallium et d'aluminium (Al Ga As). L'ensemble de la structure est supportée par un substrat 1 munie d'une couche 11 d'un semiconducteur, tel que Ga As dopé n⁺ ou d'un matériau conducteur faisant office d'électrode. Une électrode 10 est prévue sur la couche de guidage optique 8. Un générateur de tension V est connecté à l'électrode 10 et à la couche 11 de façon à appliquer un champ électrique à la structure.

De cette façon, un flux lumineux F transmis dans la couche de cristal non linéaire 7 subit une modulation sous l'effet du champ électrique appliqué.

Cette modulation peut être une modulation de phase ou une modulation de contraste selon :

- les types de matériaux utilisés par les couches de l'empilement de puits asymétriques du cristal non linéaire 7,
- le dopage de ces couches,
- la longueur d'onde à moduler,
- la longueur du dispositif dans le sens de parcours de l'onde à moduler. Dans ce qui précède on a considéré que les couches de guidage optique 8,9 sont en Al Ga As, cependant elles pourraient être en tout autre matériau permettant un guidage optique et bien évidemment en matériau semi-conducteur adapté à la réalisation de l'empilement des puits quantiques asymétriques.

A titre d'exemple, l'empilement de couche 7 peut être réalisé de la même façon que cela a été décrit en relation avec la figure 3.

La figure 10 représente un dispositif de doublage de fréquence optique. Il comprend un substrat 1 sur lequel a été réalisé un empilement 7 de couches constituant un empilement de puits quantiques asymétriques tel que décrit en relation avec la figure 3. L'empilement 7 constitue donc un cristal non linéaire à puits quantiques asymétriques.

Un puits quantité asymétrique simple recevant une onde lumineuse de fréquence h $\nu$ donne lieu à deux ondes lumineuses de fréquences h $\nu$ et 2h $\nu$.

Dans ces conditions le dispositif de la figure 10 fonctionne en doubleur de fréquence et fournit en prévoyant un grand nombre de puits quantiques asymétriques, une onde de fréquence 2h $\nu$ ayant une intensité importante.

Le substrat 1 est en matériau transparent aux ondes de fréquences h $\nu$ et 2h $\nu$.

A titre d'exemple de réalisation l'empilement 7 de couches est réalisé de telle façon que chaque puits quantique de l'empilement de puits quantique a les caractéristiques suivantes :

couches barrières =

$Al_{0,4}$ $Ga_{0,6}$ As de 30 nm d'épaisseur

couches de puits quantiques =

- Ga As = épaisseur 6nm contenant $5.10^{17}$ porteurs par $cm^3$ dû à un dopage de la structure
- $Al_{0,1}$ $Ga_{0,9}$ As = épaisseur 4,5 nm

L'invention telle que décrite précédemment concerne donc bien un type de détecteur optique ou de dispositif de traitement optique ayant en commun le fait que la partie active est un cristal réalisé sous la forme d'un empilement de puits quantiques asymétriques.

De tels dispositifs ont l'avantage de travailler à de grandes longueurs d'ondes (supérieures à 3$\mu$m) de pouvoir être intégrés en technologie à semiconducteur, et pouvoir fournir, en ce qui concerne les détecteurs, une très forte impédance à température ambiante (courant d'obscurité faible).

Il est bien évident que la description qui précède n'a été faite qu'à titre d'exemple. Les exemples numériques notamment n'ont été fournis que pour illustrer la description.

**Revendications**

1. Dispositif de détection de rayonnements optiques comprenant un cristal non linéaire comportant un empilement d'au moins deux couches (3, 4) en matériaux à largeur de bandes interdites différentes constituant au moins un puits quantique à structure asymétrique, cet empilement de couches étant enserré entre deux couches barrières (2, 5) en matériau de largeur de bande interdite supérieure à celles des couches de l'empilement ; ledit puits comportant un premier niveau d'énergie (E0) situé dans la partie profonde du puits et un deuxième niveau d'énergie (E1) située dans la partie moins profonde du puits, la détection et le traitement d'une onde optique se faisant par transition d'électrons entre ces deux niveaux, des électrodes (1, 6) étant situées sur les couches barrières en vue de connecter un dispositif de mesure de tension.

2. Dispositif de détection et de traitement selon la revendication 1, caractérisé en ce qu'il comprend un empilement de plusieurs puits quantiques à compositions asymétriques.

3. Dispositif de détection et de traitement selon la revendication 1, caractérisé en ce que les différents puits quantiques sont de caractéristiques sensiblement identiques.

4. Dispositif de détection selon l'une des revendications 2 ou 3, caractérisé en ce qu'il comporte un appareil de mesure de potentiels (V) connecté aux bornes de l'empilement de puits quantiques.

**5.** Dispositif de détection selon la revendication 4, caractérisé en ce qu'il comporte un transistor à effet de champ et qu'un empilement de plusieurs puits quantiques est intégré au drain ou à la grille du transistor à effet de champ de façon à ce qu'une tension créée entre les deux couches extrêmes de l'empilement de puits quantiques permet de commander le transistor à effet de champ.

**6.** Dispositif de détection selon l'une des revendications 2 ou 3, recevant un premier faisceau lumineux à détecter d'une longueur d'onde déterminée, caractérisé en ce qu'il comporte également une source auxiliaire d'un deuxième faisceau lumineux de même longueur d'onde que le premier faisceau et interférant avec ce premier faisceau dans le cristal non linéaire.

**7.** Procédé de réalisation d'un dispositif de détection et de traitement selon la revendication 1, caractérisé en ce que les différentes couches de matériaux constituant les empilements de puits quantiques asymétriques sont réalisées par épitaxie.

**8.** Dispositif de modulation électro-optique appliquant le dispositif selon la revendication 1, caractérisé en ce que le cristal non linéaire comportant au moins un puits quantique à composition asymétrique est compris entre deux couches de guidage optique (8, 9), sur lesquelles sont déposées deux électrodes permettant d'appliquer un champ électrique au cristal non linéaire.

**9.** Dispositif de modulation selon la revendication 8, caractérisé en ce que les couches de guidage optique (8, 9) sont en Al Ga As.

**10.** Dispositif de doublage de fréquence appliquant le dispositif selon la revendication 1 permettant de doubler une première fréquence (h $\nu$) déterminée d'un rayonnement optique en une deuxième fréquence (2h $\nu$) caractérisé en ce que le cristal non linéaire comportant au moins un puits quantique à composition asymétrique est déposé sur une couche d'un matériau transparent aux ondes de première et deuxième fréquences (h et 2h $\nu$).

**11.** Dispositif de doublage de fréquence selon la revendication 10, caractérisé en ce qu'il comporte une première électrode déposée sur le cristal non linéaire et une deuxième électrode déposée sur la couche de matériau transparent de façon à appliquer un champ électrique au cristal non linéaire.

**Claims**

**1.** Device for the detection of optical radiations comprising a nonlinear crystal containing a stack of at least two layers (3, 4) made from materials having different forbidden band widths constituting at least one quantum well having an asymmetric structure, this stack of layers being clasped between two barrier layers (2, 5) made from a material whose forbidden band width is greater than those of the layers of the stack; the said well containing a first energy level (E0) situated in the deep part of the well and a second energy level (E1) situated in the less deep part of the well, the detection and processing of an optical wave being carried out by electron transition between these two levels, electrodes (1, 6) being situated on the barrier layers with a view to connecting a voltage measurement device.

**2.** Detection and processing device according to Claim 1, characterized in that it comprises a stack of a plurality of quantum wells having asymmetric compositions.

**3.** Detection and processing device according to Claim 1, characterized in that the various quantum wells are of substantially identical characteristics.

**4.** Detection device according to one of Claims 2 or 3, characterized in that it comprises a potential measurement apparatus (V) connected to the terminals of the stack of quantum wells.

**5.** Detection device according to Claim 4, characterized in that it comprises a field effect transistor, and that a stack of a plurality of quantum wells is integrated at the drain or at the gate of the field effect transistor in such a manner that a voltage created between the two extreme layers of the stack of quantum wells permits the control of the field effect transistor.

**6.** Detection device according to one of Claims 2 or 3, receiving a first light beam to be detected of a determined wavelength, characterized in that it further comprises an auxiliary source of a second light beam of the same wavelength as the first beam and interfering with this first beam in the nonlinear crystal.

**7.** Process for the construction of a detection and processing device according to Claim 1, characterized in that the various layers of materials constituting the stacks of asymmetric quantum wells are constructed by epitaxy.

8. Electro-optical modulation device applying the device according to Claim 1, characterized in that the nonlinear crystal comprising at least one quantum well of asymmetric composition is included between two optical guiding layers (8, 9) on which are deposited two electrodes permitting the application of an electric field to the nonlinear crystal.

9. Modulation device according to Claim 8, characterized in that the optical guiding layers (8, 9) are made from Al Ga As.

10. Frequency-doubling device applying the device according to Claim 1 permitting the doubling of a first determined frequency (h $\nu$) of an optical radiation into a second frequency (2 h $\nu$) characterized in that the nonlinear crystal comprising at least one quantum well having asymmetric composition is deposited on a layer of a material which is transparent to the waves of first and second frequencies (h and 2 h $\nu$).

11. Frequency-doubling device according to Claim 10, characterized in that it includes a first electrode deposited on the nonlinear crystal and a second electrode deposited on the layer of transparent material so as to apply an electric field to the nonlinear crystal.

**Patentansprüche**

1. Vorrichtung zum Erfassen von Lichtstrahlen, die einen nicht-linearen Kristall aufweist, der eine Stapelung von mindestens zwei Schichten (3, 4) aus Materialien mit unterschiedlichen Breiten des verbotenen Bands enthält, die mindestens eine Quantensenke mit asymmetrischer Struktur bildet, wobei diese Stapelung von Schichten zwischen zwei Barriereschichten (2, 5) aus einem Material mit einer Breite des verbotenen Bands größer als der der Schichten der Stapelung besteht, wobei die Senke ein erstes Energieniveau (E0) aufweist, das im tiefen Bereich der Senke liegt, und ein zweites Energieniveau (E1), das sich im weniger tiefen Bereich der Senke befindet, wobei die Erfassung und Verarbeitung einer Lichtwelle durch Elektronenübergang zwischen diesen beiden Niveaus erfolgt, wobei Elektroden (1, 6) auf den Barriereschichten angeordnet sind, um eine Spannungsmeßvorrichtung anzuschließen.

2. Vorrichtung zur Erfassung und zur Verarbeitung nach Anspruch 1, dadurch gekennzeichnet, daß sie eine Stapelung von mehreren Quantensenken mit asymmetrischen Zusammensetzungen aufweist.

3. Vorrichtung zur Erfassung und zur Verarbeitung nach Anspruch 1, dadurch gekennzeichnet, daß die verschiedenen Quantensenken im wesentlichen identische Merkmale aufweisen.

4. Vorrichtung zur Erfassung nach einem der Ansprüche 2 oder 3, dadurch gekennzeichnet, daß sie ein Gerät zur Potentialmessung (V) aufweist, das mit den Klemmen der Stapelung von Quantensenken verbunden ist.

5. Vorrichtung zur Erfassung nach Anspruch 4, dadurch gekennzeichnet, daß sie einen Feldeffekttransistor aufweist und daß eine Stapelung von mehreren Quantensenken in den Drain oder das Gate des Feldeffekttransistors integriert ist, so daß eine zwischen den beiden Endschichten der Stapelung von Quantensenken erzeugte Spannung es ermöglicht,den Feldeffekttransistor zu steuern.

6. Vorrichtung zur Erfassung nach einem der Ansprüche 2 oder 3, die einen ersten zu erfassenden Lichtstrahl einer bestimmten Wellenlänge empfängt, dadurch gekennzeichnet, daß sie weiter eine Hilfsquelle eines zweiten Lichtstrahls der gleichen Wellenlänge wie der erste Lichtstrahl aufweist, der mit diesem ersten Lichtstrahl im nichtlinearen Kristall interferiert.

7. Verfahren zur Herstellung einer Vorrichtung zur Erfassung und Verarbeitung nach Anspruch 1, dadurch gekennzeichnet, daß die verschiedenen die Stapelungen von asymmetrischen Quantensenken bildenden Schichten von Materialien durch Epitaxie hergestellt werden.

8. Vorrichtung zur elektro-optischen Modulation, die die Vorrichtung nach Anspruch 1 verwendet, dadurch gekennzeichnet, daß der nichtlineare Kristall, der mindestens eine Quantensenke mit asymmetrischer Zusammensetzung aufweist, zwischen zwei optischen Führungsschichten (8, 9) liegt, auf die zwei Elektroden aufgebracht sind, die es ermöglichen, ein elektrisches Feld an den nichtlinearen Kristall anzulegen.

9. Vorrichtung zur Modulation nach Anspruch 8, dadurch gekennzeichnet, daß die optischen Führungsschichten (8, 9) aus Al-GaAs sind.

10. Vorrichtung zur Frequenzverdoppelung, die die Vorrichtung nach Anspruch 1 verwendet, die es ermöglicht, eine Lichtstrahlung einer ersten bestimmte Frequenz (h$\nu$) in eine Lichtstrahlung

einer zweiten, doppelten Frequenz ($2h\nu$) zu verwandeln, dadurch gekennzeichnet, daß der nichtlineare Kristall, der mindestens eine Quantensenke mit asymmetrischer Struktur aufweist, auf eine Schicht eines für die Wellen der ersten und der zweiten Frequenz ($h\nu$ und $2h\nu$) durchlässigen Materials aufgebracht ist.

11. Vorrichtung zur Frequenzverdoppelung nach Anspruch 10, dadurch gekennzeichnet, daß sie eine erste Elektrode aufweist, die auf den nichtlinearen Kristall aufgebracht ist, und eine zweite Elektrode aufweist, die auf die Schicht ans durchlässigem Material aufgebracht ist, so daß an den nichtlinearen Kristall ein elektrisches Feld angelegt wird.

FIG.1

FIG.2

FIG.3

FIG.4

ONDE

CHOPPER

FE

DET

ISO

OX1

GRILLE

DRAIN

OX0

SOURCE

SORTIE

Ga As

n+

n+

FET

Ga As   SI

## FIG. 5

CHARGES

## FIG.6

COEFFICIENT
DE DOUBLAGE
DE FREQUENCE
$(F/V \times 1/9 \times 10^{-16})$

micromètres

λ

FIG.7

OBJET

M1

Fd

SO

SOURCE

POMPE
Fp

F1

DET

AMPLIFICATION

FIG.8

13

## FIG_9

## FIG_10